# EUROPEAN PATENT SPECIFICATION

(11) **EP 2 405 182 B1**
(45) Date of publication and mention of the grant of the patent: **17.02.2016**
(21) Application number: 11172732.7
(22) Date of filing: 05.07.2011
(51) Int. Cl.: F21S 4/00, F21V 9/16, H01L 33/50, H01L 33/60, H01L 25/075

(54) **Light emitting device**
Lichtemittierende Vorrichtung
Dispositif électroluminescent

(30) Priority: 05.07.2010 JP 2010153429; 26.08.2010 JP 2010190044
(43) Date of publication of application: 11.01.2012
(73) Proprietor: Panasonic Intellectual Property Management Co., Ltd., Osaka 540-6207 (JP)
(72) Inventor: Tanaka, Kenichiro, Neyagawa, Osaka (JP); Kiba, Keiji, Shijounawate, Osaka (JP); Yokotani, Ryoji, Hirakata, Osaka (JP)
(74) Representative: Rüger, Barthelt & Abel

(56) References cited:
- US-A1- 2008 212 336
- US-A1- 2009 201 679
- US-A1- 2009 219 713

## Description

### [Field of the Invention]

The present invention relates to a light emitting device that uses a plurality of solid-state light emitting elements as a light source and is applied to an illumination device or the like.

### [Background Art]

There has been known a light emitting device in which a plurality of solid-state light emitting elements are mounted on a board. In general, as the plurality of solid-state light emitting elements, a plurality of light emitting diodes (hereinafter referred to as LEDs) that emit blue light are used. In this sort of light emitting device, the plurality of LEDs mounted on the board are sealed by a translucent resin layer on an LED-by-LED basis. The plurality of LEDs sealed by the translucent resin layer are covered by a wavelength converting member. The wavelength converting member contains phosphors that convert the blue light emitted from the plurality of LEDs to, for example, yellow light. Based on this, when the blue light is irradiated on the phosphors, the yellow light is emitted from the phosphors. As a result, the blue light not irradiated on the phosphors and the yellow light are combined, and emitted as white light from a surface of the wavelength converting member (see, for example, JPA 2010-123918 (Fig. 1 and claim 1) and JPA 2010-129615).

US 2008/0212336 A1 being the closest prior art shows a light emitting device comprising:
▪ a plurality of solid-state light emitting elements that are mounted on a carrier;
▪ an optical member mounted on the carrier that is provided in common so as to cover the plurality of solid-state light emitting elements, the optical member has the form of a plate; and
▪ a wavelength converting member that covers a light lead-out surface of the optical member, is excited by light led out of the solid-state light emitting elements, and emits wavelength-converted light.

### [Disclosure of the Invention]

### [Problems to be solved by the Invention]

Typically, in the light emitting device, the solid-state light emitting elements are provided with being scattered. However, the phosphors in the solid-state light emitting elements are not necessarily uniform, and therefore color unevenness occurs as a whole. Also, a light emitting part of the solid-state light emitting element is small in size, and therefore luminance of the light emitting part is increased to thereby give rise to glare. A light emitting device described in above-described Patent literature 1 is one that is proposed to solve these problems, and leads out light through a fluorescent substance layer and a diffusion layer that are provided in common with being separated from a solid-state light emitting element array.

However, the light emitting device described in above-described Patent literature 1 has two problems described below. A first problem is that although the fluorescent substance layer is arranged with being separated from the solid-state light emitting elements, a sealing member is in close contact with the fluorescent substance layer through an adhesive layer, so that emission light from the solid-state light emitting elements is directly incident on the fluorescent substance layer, and an incident density on the fluorescent substance layer becomes uneven depending on light distribution of the solid-state light emitting elements or distance between the solid-state light emitting elements to thereby give rise to luminance unevenness. Also, a distribution of incident angles on respective sites of the fluorescent substance layer becomes uneven to give rise to color unevenness. A second problem is that the fluorescent substance layer has a plate-like shape, so that a component of which an incident angle from the solid-state light emitting elements onto the fluorescent substance layer is large is easily reflected, and therefore light extraction efficiency is reduced.

Also, in the light emitting device as described above, positions where the LEDs are mounted on the board, and amounts of the translucent resin layer that seals the LEDs are uneven among the plurality of LEDs, and therefore distances between the LEDs and the wavelength converting member become uneven. As a result, luminance and color of the light emitted from the surface of the wavelength converting member vary depending on a position on the surface, and therefore luminance unevenness and color unevenness may occur.

The present invention is made in order to solve the conventional problems, and has an object to provide a light emitting device that can reduce luminance unevenness and color unevenness in a light emitting part, and form an even and continuous light emitting surface.

### [Means adapted to solve the Problems]

A light emitting device according to the present invention is provided with: a plurality of solid-state light emitting elements that are mounted on a long-sized wiring board: an optical member that is provided in common so as to cover the plurality of solid-state light emitting elements to be thereby sealed, mounted, and fixed, the optical member has a semicircular or semielliptical cross-sectional shape, and is gutter-shaped in a longer direction; and a wavelength converting member that covers a light lead-out surface of the optical member, is excited by light led out of the solid-state light emitting elements, and emits wavelength-converted light.

A light emitting element according to the present invention is configured such that a region of a surface of the wiring board has a high reflectance, the region including at least a lower surface of the optical member.

A light emitting device according to the present invention is configured such that between the optical member and the wavelength converting member, an air layer is present.

A light emitting device according to the present invention is configured such that the optical member has, between the optical member and the wiring board mounted with the solid-state light emitting elements, a concave portion that contains the plurality of solid-state light emitting elements, and in a state where the concave portion contains the solid-state light emitting elements, a part of the optical member is embedded in the concave portion.

A light emitting device according to the present invention is configured such that at least ones of end sides of the wiring board and the wavelength converting member substantially coincide in position with each other, the ones being on the same side.

A light emitting device according to the present invention is configured such that the optical member includes a plurality of optical parts, and integrally formed in a substantially long-sized shape.

A light emitting device according to the present invention is configured such that the wavelength converting member includes a plurality of wavelength converting parts, and is integrally formed in a substantially long-sized shape.

A light emitting device of the present invention is provided with: a plurality of solid-state light emitting elements; a first translucent resin layer that covers the plurality of solid-state light emitting elements; a light converting part that covers a light lead-out surface of the first translucent resin layer directly or through a second translucent resin layer or an air layer, and contains a phosphor that converts a wavelength of emission light of the plurality of solid-state light emitting elements; and a diffusion part that is formed between the plurality of solid-state light emitting elements and diffuses the light emitted from the plurality of solid-state light emitting elements.

In the light emitting device, preferably, the diffusion part is formed in the first translucent resin layer.

In the light emitting device, preferably, the diffusion part is formed on the light lead-out surface of the first translucent resin layer.

In the light emitting device, preferably, the diffusion part is formed between the first translucent resin layer and the light converting part.

In the light emitting device, preferably, the diffusion part is formed in the light converting part.

In the light emitting device, preferably, the diffusion part has a diffusion degree that is increased toward an intermediate position between mutually adjacent solid-state light emitting elements, and is decreased toward any of the solid-state light emitting elements.

In the light emitting device, preferably, the diffusion part is formed on a board mounted with the plurality of solid-state light emitting elements; a vertically cross-sectional shape of the diffusion part along one side of the board is a triangle; an inclination angle of the triangle on a side close to a solid-state light emitting element is small; and an inclination angle of the triangle on a side distant from the solid-state light emitting element is large.

In the light emitting device, preferably, the plurality of solid-state light emitting elements are arranged in a linear shape, a planar shape, or a stereoscopic surface shape.

### [Effect of the Invention]

According to the light emitting device according to the present invention, effects that can reduce luminance unevenness and color unevenness in a light emitting part, and form an even and continuous light emitting surface are produced.

Also, according to the light emitting device according to the present invention, the light emitted from the plurality of solid-state light emitting elements is diffused by the diffusion part formed between adjacent light emitting elements, and irradiated on the light converting part containing the phosphor through the first translucent resin layer. For this reason, in both of the light converting part positioned above the solid-state light emitting elements and the light converting part positioned above the diffusion part, the light substantially equally passes, and therefore the luminance unevenness and color unevenness can be reduced.

### [Brief Description of the Drawings]

[Fig. 1] Fig. 1 is an exploded perspective view of a light emitting device of a first embodiment according to the present invention.
[Fig. 2] Fig. 2 is a vertical cross-sectional view of the light emitting device of Fig. 1 in a longer direction.
[Fig. 3] Fig. 3 is a vertical cross-sectional view of the light emitting device of Fig. 1 in a shorter direction.
[Fig. 4] Fig. 4 is an appearance perspective view of an optical member in the light emitting device of Fig. 1.
[Fig. 5] Fig. 5 is an appearance perspective view of a wavelength converting member of the light emitting device of Fig. 1.
[Fig. 6] Fig. 6 is a vertical cross-sectional view in the shorter direction for describing an optical characteristic of the light emitting device of Fig. 1.
[Fig. 7] Fig. 7 is a vertical cross-sectional view of a light emitting device of a second embodiment according to the present invention in a longer direction.
[Fig. 8] Fig. 8 is a vertical cross-sectional view of the light emitting device of Fig. 7 in a shorter direction.
[Fig. 9] Fig. 9 is a plan view of the light emitting device of Fig. 7.
[Fig. 10] Fig. 10 is a plan view illustrating an internal structure of the light emitting device of Fig. 7.
[Fig. 11] Fig. 11 is a vertical cross-sectional view in the longer direction for describing an optical characteristic of the light emitting device of Fig. 7.
[Fig. 12] Fig. 12 is a plan view of a variation of the light emitting device of Fig. 7.
[Fig. 13] Fig. 13 is a plan view of a light emitting device of a third embodiment according to the present invention.
[Fig. 14] Fig. 14 is a vertical cross-sectional view of the light emitting device of Fig. 13 in a shorter direction.
[Fig. 15] Fig. 15 is a vertical cross-sectional view of an illumination device applied with the light emitting device of Fig. 13.
[Fig. 16] Fig. 16 is a vertical cross-sectional view of a variation of the light emitting device of Fig. 13 in the shorter direction.
[Fig. 17] Fig. 17 is an appearance perspective view of a light emitting device of a fourth embodiment according to the present invention.
[Fig. 18] Fig. 18 is a vertical cross-sectional view of the light emitting device of Fig. 17 in a longer direction.
[Fig. 19] Fig. 19 is a vertical cross-sectional view of the light emitting device of Fig. 17 in a shorter direction.
[Fig. 20] Fig. 20 is an appearance perspective view of a light emitting device of a fifth embodiment according to the present invention.
[Fig. 21] Fig. 21 is a vertical cross-sectional view of the light emitting device of Fig. 20 in a longer direction.
[Fig. 22] Fig. 22 is a vertical cross-sectional view of the light emitting device of Fig. 20 in a shorter direction.
[Fig. 23] Fig. 23 is an appearance perspective view of a light emitting device of a sixth embodiment according to the present invention.
[Fig. 24] Fig. 24 is a plan view of the light emitting device of Fig. 23.
[Fig. 25] Fig. 25 is an appearance perspective view of a variation of the light emitting device of Fig. 23.
[Fig. 26] Fig. 26 is a vertical cross-sectional view of a light emitting device of a seventh embodiment according to the present invention in a longer direction.
[Fig. 27] Fig. 27 is a vertical cross-sectional view of the light emitting device of Fig. 26 in a shorter direction.

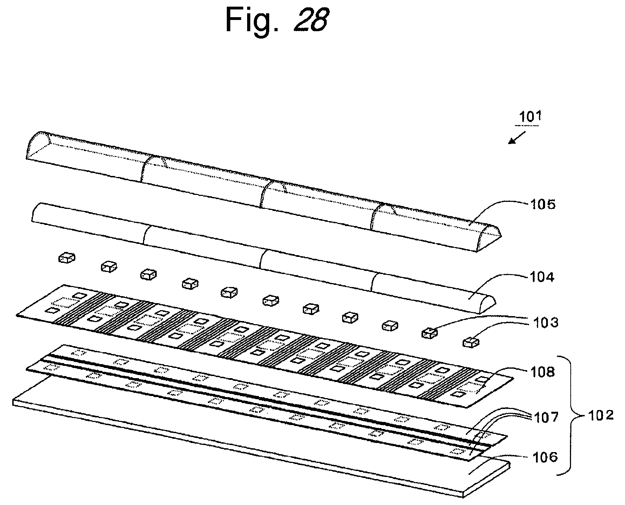

[Fig. 28] Fig. 28 is an exploded perspective view of a light emitting device according to one embodiment of the present invention.
[Fig. 29] Fig. 29 (a) is a top view of the device, (b) is an A-A line cross-sectional view in (a), and (c) is a B-B line cross-sectional view in (a).

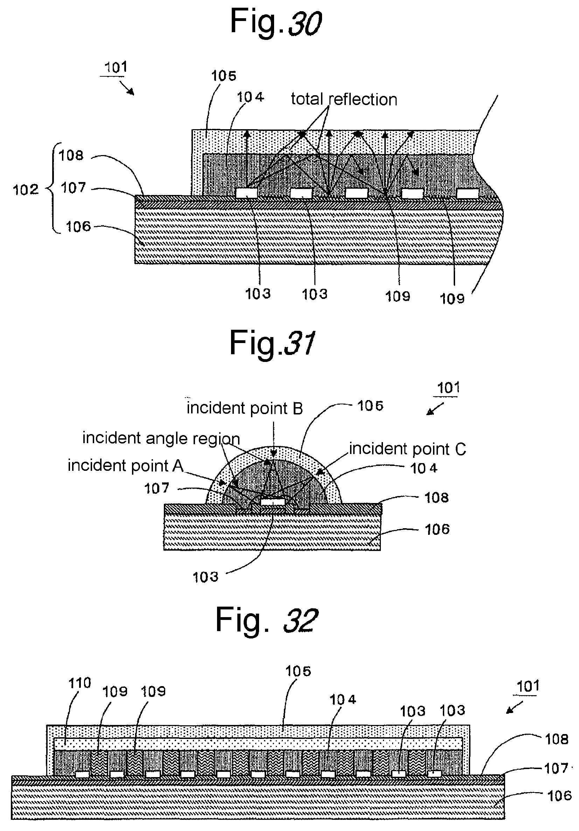

[Fig. 30] Fig. 30 is a cross-sectional view illustrating a light emitting method of the device.
[Fig. 31] Fig. 31 is a cross-sectional view illustrating a light emitting method of the device.
[Fig. 32] Fig. 32 is a cross-sectional view of a light emitting device of an eighth embodiment according to the present invention.

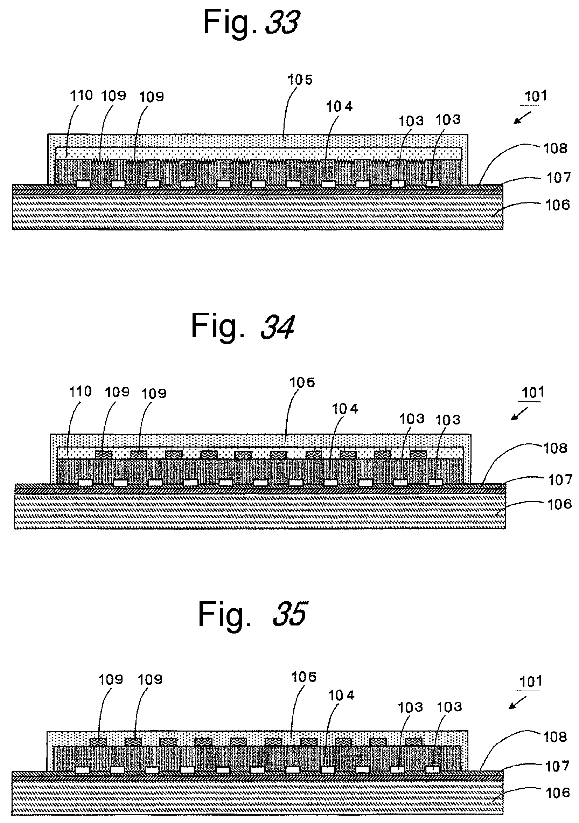

[Fig. 33] Fig. 33 is a cross-sectional view of a light emitting device of a ninth embodiment according to the present invention.
[Fig. 34] Fig. 34 is a cross-sectional view of a light emitting device of a tenth embodiment according to the present invention.
[Fig. 35] Fig. 35 is a cross-sectional view of a light emitting device of an eleventh embodiment according to the present invention.

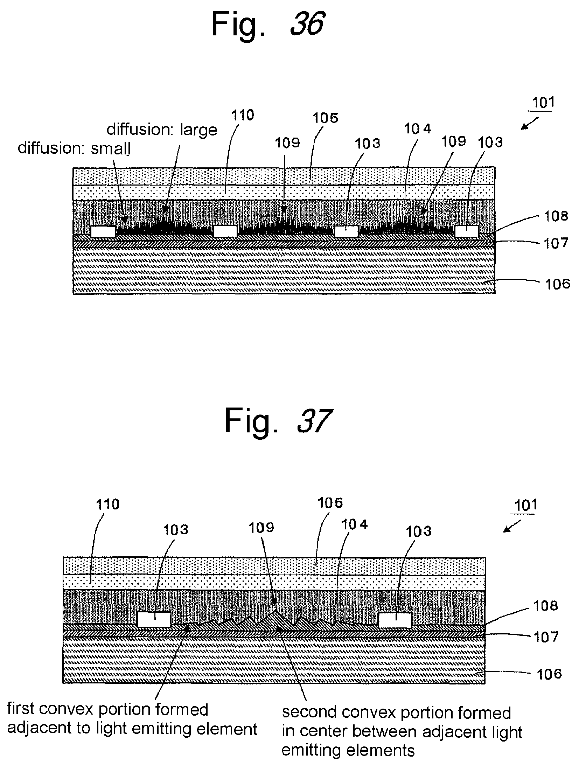

[Fig. 36] Fig. 36 is a cross-sectional view of a light emitting device of a twelfth embodiment according to the present invention.
[Fig. 37] Fig. 37 is a cross-sectional view of a light emitting device of a thirteenth embodiment according to the present invention.

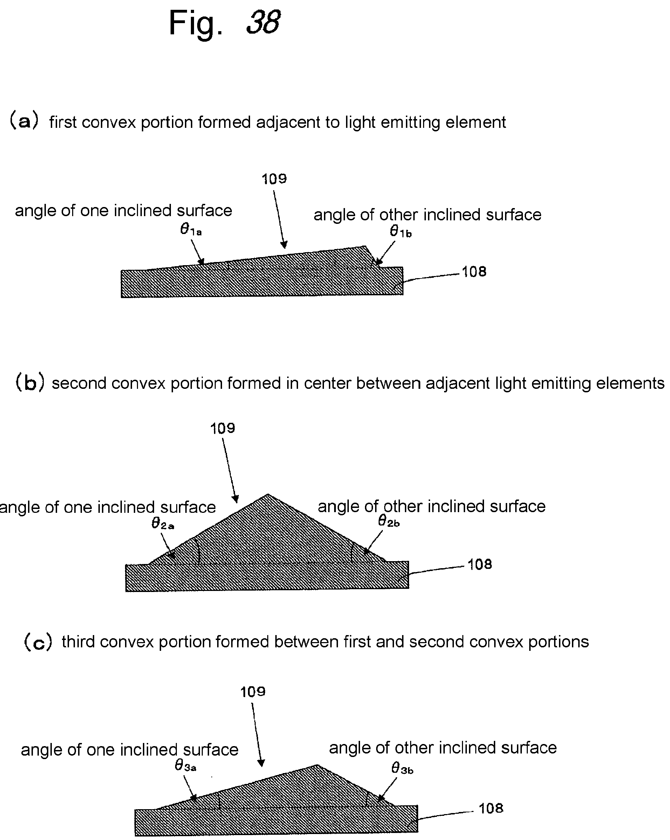

[Fig. 38] Fig. 38 is an enlarged cross-sectional view illustrating a configuration of a diffusion part of the same embodiment.

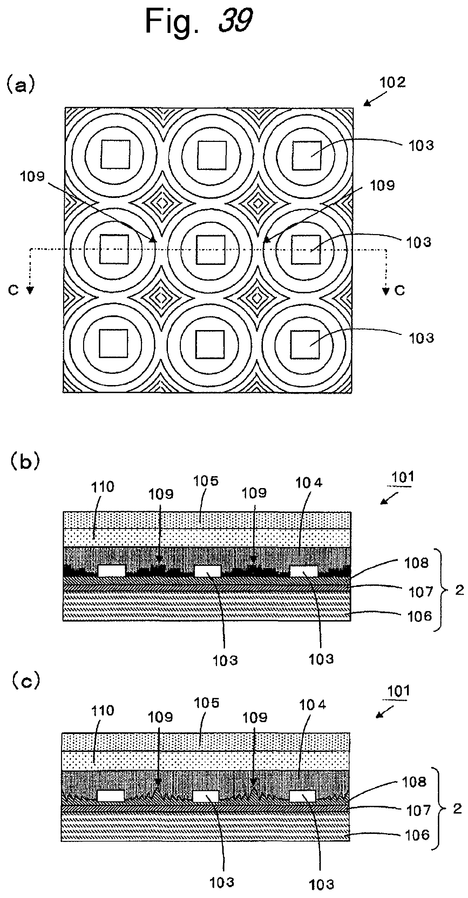

[Fig. 39] Fig. 39 (a) is a top view of a light emitting device of a fourteenth embodiment according to the present invention, (b) is a C-C line cross-sectional view in (a), and (c) is a cross-sectional view of an example of a different diffusion part shape in the same embodiment.

### [Best Mode for Carrying Out the Invention]

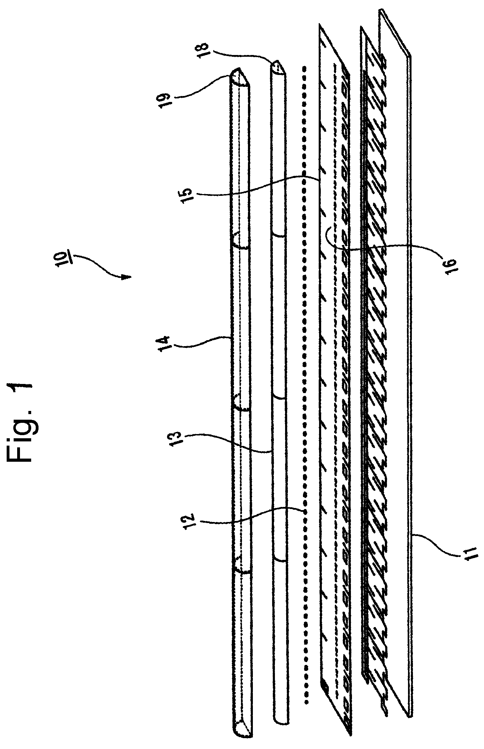

Light emitting devices of a plurality of embodiments according to the present invention will hereinafter be described with use of the drawings. (First embodiment) As illustrated in Fig. 1, a light emitting device 10 of a first embodiment according to the present invention is provided with: a long-sized wiring board 11; a plurality of solid-state light emitting elements 12 mounted on the wiring board 11; an optical member 13 that is provided in common so as to cover light emitting surfaces of the plurality of solid-state light emitting elements 12; and a wavelength converting member 14 that covers a light lead-out surface of the optical member 13, and is excited by light led out of the solid-state light emitting elements 12 to emit wavelength-converted light.

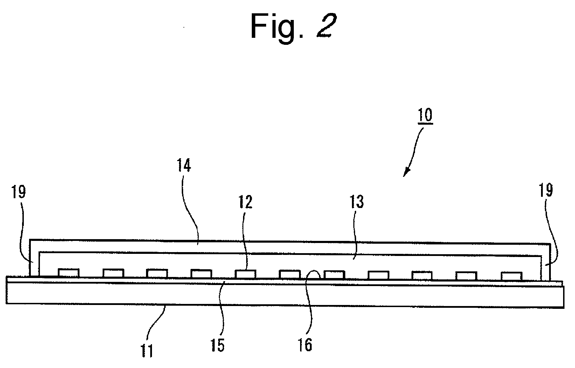

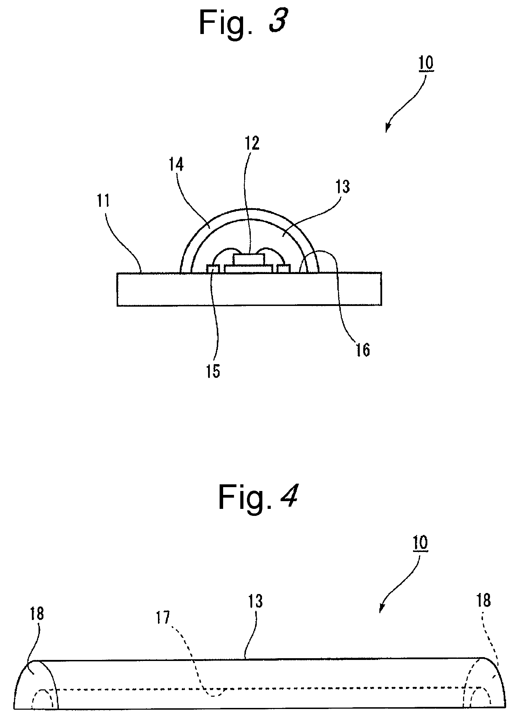

As illustrated in Figs. 2 and 3, the wiring board 11 is molded with use of metal such as aluminum, glass epoxy, or ceramics as a base material. The wiring board 11 has an upper surface provided with a wiring pattern 15 for supplying electricity to the solid-state light emitting elements 12. On an upper surface of the wiring pattern 15, a white resist 16 is provided. The wiring board 11 is of a long-sized shape having, for example, a length dimension of 200 mm × a width dimension of 20 mm.

Each of the solid-state light emitting elements 12 is a nitride semiconductor (LED) and emits blue light having an emission peak wavelength of 460 nm. Each of the solid-state light emitting elements 12 has a size of 0.3 mm. The plurality of solid-state light emitting elements 12 are mounted on the wiring board 11 in a line in a longer direction at regular intervals. A mounting method for the solid-state light emitting elements 12 employs a combination of die bonding and wire bonding. As the mounting method, flip-chip bonding may be used. The type and size of the solid-state light emitting element 12 are not limited to the above-described ones. In addition, the solid-state light emitting element 12 group is not mounted in one line, but may be mounted in a plurality of lines. In such a case, a size of a cross section of the optical member 13 is only required to be equal to or more than a number obtained by multiplying a size of a circumscribed circle of the solid-state light emitting element 12 group within the cross section by a refractive index of the optical member 13.

As illustrated in Fig. 4, the optical member 13 is made of transparent silicone resin; has a semicircular outer cross section; is gutter-shaped in the longer direction; and has a size capable of cover the solid-state light emitting element 12 group. The optical member 13 has a diameter of the outer cross section equal to or more than the number obtained by multiplying a diameter of the circumscribed circle of the solid-state light emitting elements 12 by the refractive index (in the case of the silicone resin, 1.41 times) of the optical member 13. Inside the optical member 13 including a center of the cross section, a concave portion 17 is formed, and has a size capable of containing the solid-state light emitting element 12 group inside. At both ends of the optical member 13, lid parts 18 not having the concave portion 17 are formed. The concave portion 17 inside the optical member 13 is filled with silicone resin having the same refractive index as that of the optical member 13, and the optical member 13 is mounted on the wiring board 11 so as to cover the solid-state light emitting element 12 group to be thereby sealed, mounted, and fixed. The optical member 13 has a structure integrated with the sealing resin after curing, and therefore does not give rise to any interface. The optical member 13 has a central axis that corresponds to a mounting axis of the solid-state light emitting element 12 group. Note that a material for the optical member 13 is not limited to the silicone resin, but may be, for example, epoxy resin, or an inorganic material such as glass. Also, the outer cross-sectional shape of the optical member 13 is not limited to the semicircular shape, but may be a semielliptical shape.

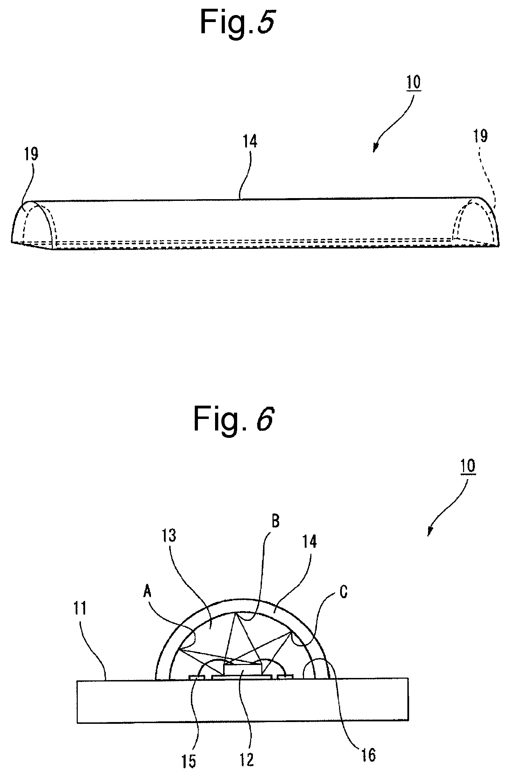

As illustrated in Fig. 5, the wavelength converting member 14 is made of a mixed material in which in transparent heat-resistant resin (e.g., silicone resin) having a refractive index of 1.2 to 1.5, particulate yellow phosphors that are excited by blue light emitted from the solid-state light emitting elements 12 to emit yellow light are dispersed. The wavelength converting member 14 may employ as phosphors dispersed in the translucent material, without limitation to the yellow phosphors, phosphors having a plurality of colors with mixing the colors for the purposes of color adjustment, increasing color rendering properties, and the like, and for example, employs red phosphors and green phosphors to thereby obtain white light having high color rendering properties. The wavelength converting member 14 is formed in a sheet-like shape having a thickness of 0.5 to 1 mm that is molded into a shape coming into close contact with the optical member 13, and at both ends thereof, lid parts 19 having a thickness thinner than a thickness of a curved part are formed. The wavelength converting member 14 has a shape similar to the optical member 13, and is therefore mounted so as to cover the optical member 13 through silicone resin with being in close contact with the optical member 13. Note that the wavelength converting member 14 may be formed by being coated on a surface of the optical member 13.

Next, optical characteristics of the light emitting device 10 are described. As illustrated in Fig. 6, the blue light emitted from the solid-state light emitting element 12 group is incident on the wavelength converting member 14 through the optical member 13; a part thereof is converted in wavelength by the phosphors inside the wavelength converting member 14 to emit wavelength-converted light; and the wavelength-converted light is mixed with the blue light, which is emitted without being converted in wavelength, and emitted from a surface of the wavelength converting member 14 as the white light. Light emitted from a single solid-state light emitting element 12 does not diverge because the wavelength converting member 14 has a semi-circular shape around the solid-state light emitting element 12 and a sufficiently large size with respect to an emission surface of the solid-state light emitting element 12, and therefore an angle distribution among light components incident on arbitrary incident points A, B, and C in the cross section of the wavelength converting member 14 is small. For this reason, a surface reflection component at an interface on an emission surface of the wavelength converting member 14 is reduced. This allows the light emitting device 10 to efficiently extract the light. Further, a distribution in light path length inside the wavelength converting member 14 is uniformized at an arbitrary point of the wavelength converting member 14, and therefore color unevenness and luminance unevenness can be reduced.

According to the above-described light emitting device 10 of the first embodiment according to the present invention, the cross-sectional shapes of the optical member 13 including any of the solid-state light emitting elements 12 and the wavelength converting member 14 are semicircular around the solid-state light emitting element 12, and therefore lights emitted from the solid-state light emitting element 12 in a cross-sectional direction of the optical member 13 are all incident on the wavelength converting member 14 so as to have the small angle distribution. Therefore, according to the light emitting device 10 of the first embodiment according to the present embodiment, the color unevenness and luminance unevenness can be reduced. Also, according to the light emitting device 10 of the first embodiment according to the present invention, as compared with a structure in which the solid-state light emitting elements 12 are arrayed, a surface area of the wavelength converting member 14 is increased, so that luminance of the light emitting part is reduced, and thereby glare can be reduced.

### (Second embodiment)

Next, a light emitting device of a second embodiment according to the present invention is described. Note that, in the following respective embodiments, the same components as those in the above-described first embodiment or functionally similar components to those in the above-described first embodiment are denoted by the same symbols or equivalent symbols to thereby simplify or omit description thereof.

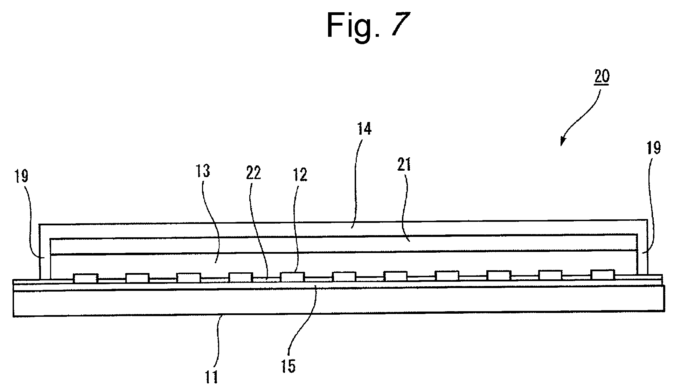

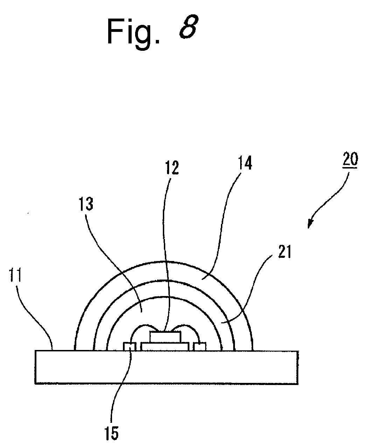

As illustrated in Figs. 7 and 8, the light emitting device 20 of the second embodiment according to the present invention has a high reflectance region that is on a surface of a wiring board 11 and includes a lower surface of an optical member 13, and has an air layer 21 between the optical member 13 and a wavelength converting member 14. The wavelength converting member 14 has a thickness of, for example, 0.5 to 1 mm, and a lower surface of the wavelength converting member 14 and the wiring board 11 are joined to each other through silicone resin. Also, the light emitting device 20 has a high reflective white resist film 22 in a region other than mounting parts and wire bonding parts of solid-state light emitting elements 12 on a surface of the wiring board 11 to thereby achieve high reflectance. The lower surface of the optical member 13 has high diffusion reflectance properties.

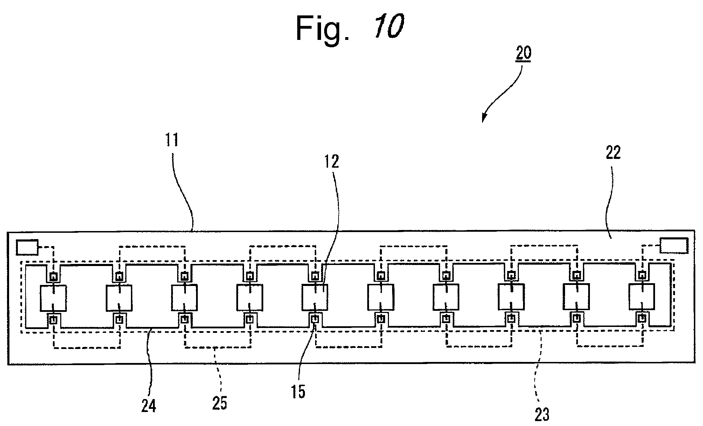

As illustrated in Fig. 10, the light emitting device 20 is configured such that, in an optical member mounting part 23 on which the optical member 13 is mounted, a die bonding pattern 24 and energizing pattern 25 for the solid-state light emitting elements 12 are separated from each other; the die bonding pattern 24 substantially coincides with the lower surface of the optical member 13; and the energizing pattern 25 has a pattern configuration that extends from outside the die bonding pattern 25 to vicinities of the solid-state light emitting elements 12 with use of narrow lines. The die bonding pattern 24 is not covered with the white resist film 22, but exposed outside as a pattern. The die bonding pattern 24 may be subjected to high reflection processing such as silver plating or aluminum evaporation.

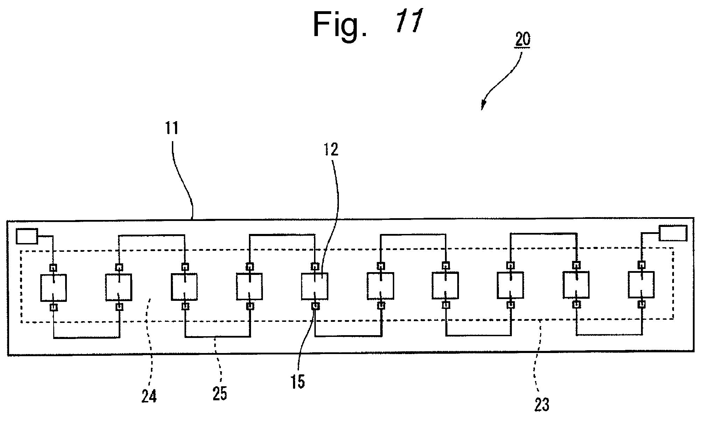

As illustrated in Fig. 11, a variation of the light emitting device 20 is applied with a wiring board 11 made of highly reflective ceramic, and only the requisite minimum of the energizing pattern 25 formed on the wiring board 11 is formed within the lower surface of the optical member 13.

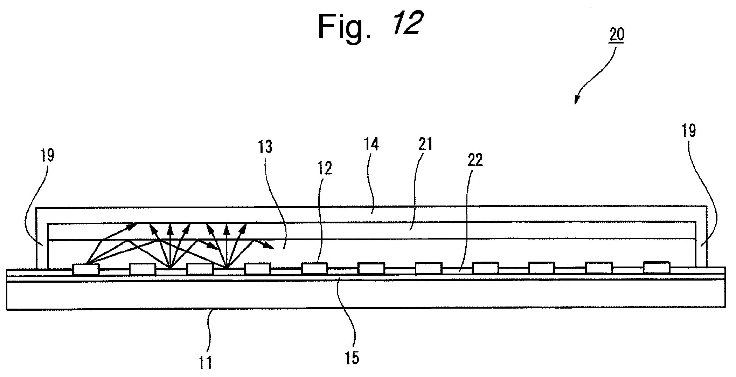

Next, an optical characteristic of the light emitting device 20 is described. As illustrated in Fig. 12, between the optical member 13 and the wavelength converting member 14, the air layer 21 is present, so that, in a light component traveling in a longer direction of the optical member 13, a total reflection component is increased at an interface on an emission surface of the optical member 13, and therefore a light guiding action in the longer direction works. At this time, light that is diffusely reflected on the reflection surface of the wiring board 11 on the lower surface of the optical member 13 and thereby changed in angle is evenly emitted at an arbitrary point from the optical member 13. This allows a light component (incident amount, incident angle distribution) incident on an arbitrary point of the wavelength converting member 14 to become more even, and color unevenness and luminance unevenness in the wavelength converting member 14 serving as a light emitting part to become more even. Also, if a void occurs inside in the process of molding of the optical member 13 or mounting on the wiring substrate 11, light from the solid-state light emitting elements 12 is changed in angle due to the void, and therefore in emission light from an outer surface of the optical member 13, unevenness occurs. In this case, if as in the light emitting device 10, the wavelength converting member 14 is in close contact with the optical member 13, the emission light unevenness gives rise to luminance unevenness on the surface of the wavelength converting member 14 serving as the light emitting part in a transferred form. However, in the light emitting device 20, the wavelength converting member 14 is separated from the optical member 13, and therefore the influence of the transfer is reduced.

According to the light emitting device 20 of the second embodiment according to the present invention, blue light reflected on the wavelength converting member 14 and yellow light emitted on the solid-state light emitting element 12 side are reflected on the surface of the wiring board 11 to be re-incident on the wavelength converting member 14, and then emitted outside the light emitting device 20. For this reason, according to the light emitting device 20 of the second embodiment according to the present invention, light extraction efficiency can be improved. Also, according to the light emitting device 20 of the second embodiment according to the present invention, if the reflective surface on the surface of the wiring board 11 is a diffuse reflective surface, the re-incident component can be evenly incident on the wavelength converting member 14, and therefore the luminance unevenness and color unevenness in the longer direction can be reduced.

Also, according to the light emitting device 20 of the second embodiment according the present invention, the air layer 21 is present between the optical member 13 and the wavelength converting member 14, so that the total reflection component is increased at the interface on the light lead-out surface of the optical member 13, and therefore the light guiding action in the longer direction works. At this time, the light diffusely reflected on the reflection surface of the wiring board 11 on the lower surface of the optical member 13 is emitted from the optical member 13, so that a light component incident on an arbitrary point of the wavelength converting member 14 becomes more even, and therefore the color unevenness and luminance unevenness become even. Also, according to the light emitting device 20 of the second embodiment according to the present invention, the wavelength converting member 14 is separated from the optical member 13, so that unevenness in blue light emission distribution due to a void occurring inside the optical member 13 is not transferred to the wavelength converting member 14, and therefore the luminance unevenness in the light emitting part can be reduced. Further, according to the light emitting device 20 of the second embodiment according to the present invention, out of optical components of incident light on the wavelength converting member 14 and converted light generated inside, which are emitted on the solid-state light emitting element 12 side, a component totally reflected on the inner surface of the wavelength converting member 14 is increased, and therefore light extraction efficiency can be improved.

### (Third embodiment)

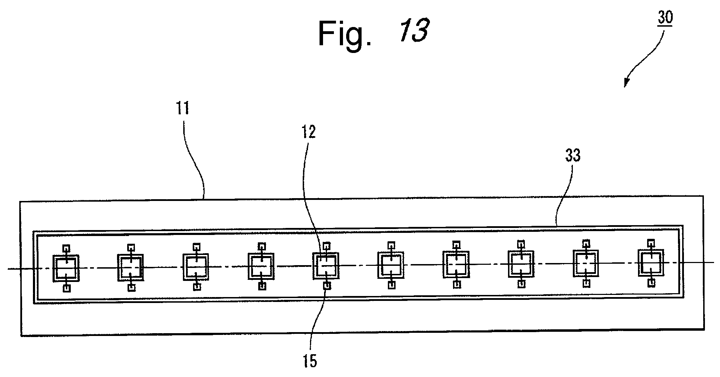

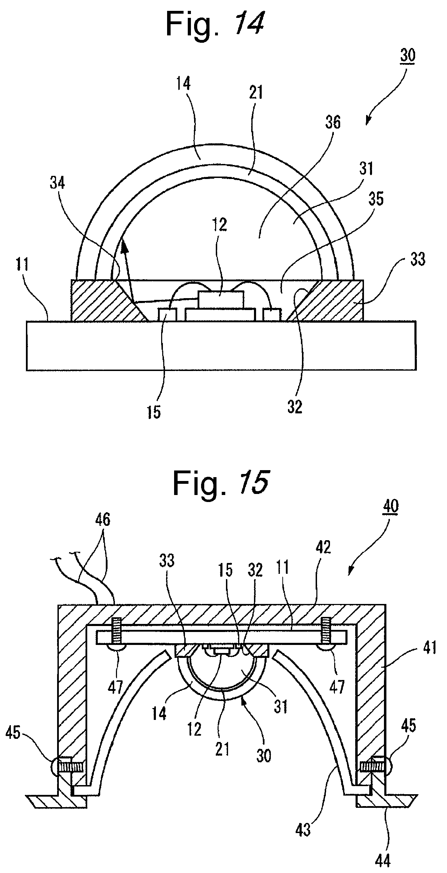

Next, a light emitting device of a third embodiment according to the present invention is described. As illustrated in Figs. 13 and 14, the light emitting device 30 of the third embodiment according to the present invention is, between an optical member 31 and a wiring board 11 mounted with solid-state light emitting elements 12, provided with a frame body 33 having a concave portion 32 containing the plurality of solid-state light emitting elements 12, and in a state where in the concave portion 32 of the frame body 33, the solid-state light emitting elements 12 are contained, a part of the concave portion 32 is embedded in the optical member 31.

The frame body 33 has a height enough to contain the solid-state light emitting elements 12 including a bonding wire part around the solid-state light emitting element 12 group on the wiring board 11; an inner shape thereof is a tapered shape that is narrowed toward the wiring board 11 at, for example, 45 degrees; and an upper opening part 34 has an outside diameter that is almost the same as that of the optical member 31. The frame body 33 is mounted on the wiring board 11 through an adhesive (made of silicone), and at least an inner surface thereof has high reflectance. The frame body 33 is made of highly reflective polybutylene terephthalate. Note that the tapered shape of the frame body 33 is not limited to a shape having the 45 degrees. Also, the frame body 33 may be made of metal such as aluminum, or heat resistant resin, or one having an inner surface on which aluminum or silver is evaporated, or made of highly reflective ceramic. Also, the frame body 33 may be a ceramic substrate formed integral with the concave portion 32.

The optical member 31 is mounted with a part thereof being inserted into the frame body 33. The wavelength converting member 14 is bonded and fixed onto the frame body 33 through silicone resin at end parts thereof. Note that the wavelength converting member 14 may be fixed to the wiring board 11 by joining so as to cover the frame body 33.

Next, a procedure for forming the optical member 31 in the light emitting device 30 is described. When the optical member 31 is formed, first, the concave portion 32 of the frame body 33 is filled with a transparent silicone resin material 35. Then, a transparent member material 36 that is formed of transparent resin similar to the transparent silicone resin material 35; has a semicircular cross-sectional shape, and is gutter-shaped in a longer direction is joined through the transparent silicone resin material 35. This enables the optical member 31 to be easily manufactured without giving rise to any void inside thereof.

As illustrated in Fig. 15, an illumination device 40 applied with the light emitting device 30 is a base light embedded in a ceiling surface, and a lower surface of a top plate 42 of a fixture main body 41 opened downward is attached with the illumination device 30. The front of the light emitting device 30 is attached with a light distribution controlling reflector 43, and an opening side end part of the fixture main body 41 is attached with a gutter-shaped metallic frame member 44 with fixing screws 45. From the wiring board 11, a power supply line 46 for energizing the solid-state light emitting elements 12 is drawn out, and electrically connected to an unillustrated power supply device outside the fixture main body 41. The wiring board 11 is attached onto the lower surface of the top plate 42 of the fixture main body 41 by screws 47. Note that the light distribution controlling reflector 43 may be a lens.

In the illumination device 40 applied with the light emitting device 30, light emitted horizontally and downward from side surfaces of the solid-state light emitting elements 12 is reflected upward by the inner surface of the frame body 33, and the lower surface opening part of the light distribution controlling reflector 43 is arranged below a top end of the frame body 33, so that the light can be efficiently incident on the light distribution controlling reflector 43. Also, the illumination device 40 does not give rise to leak light from the light distribution controlling reflector 43.

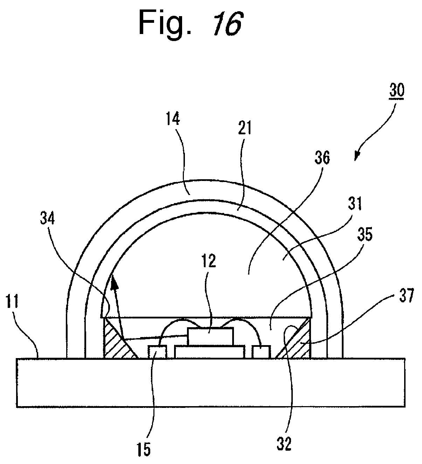

As illustrated in Fig. 16, a variation of the light emitting device 30 is configured such that an end part of the wavelength converting member 14 is joined to the wiring board 11 so as to cover a frame body 37. In the present variation, an outer shape of the frame body 37 can be decreased in size.

According to the light emitting device 30 of the third embodiment according to the present invention, when the optical member 31 is formed, the concave portion 32 of the frame body 33 or 37 is filled with the transparent silicone resin material 35, and then, the transparent member material 36 that is formed of transparent resin similar to the transparent silicone resin material 35; has a semicircular cross-sectional shape, and is gutter-shaped in the longer direction is joined through the transparent silicone resin material 35. According to the light emitting device 30 of the third embodiment according to the present invention, this enables the optical member 31 to be easily manufactured without giving rise to any void inside thereof.

Also, according to the light emitting device 30 of the third embodiment according to the present invention, yield can be improved and a manufacturing process can be simplified, so that manufacturing cost can be significantly reduced. Also, fixture efficiency of the illumination device 40 can be significantly improved.

### (Fourth embodiment)

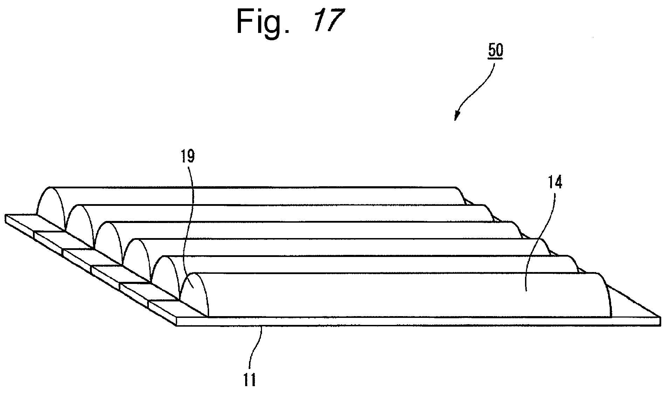

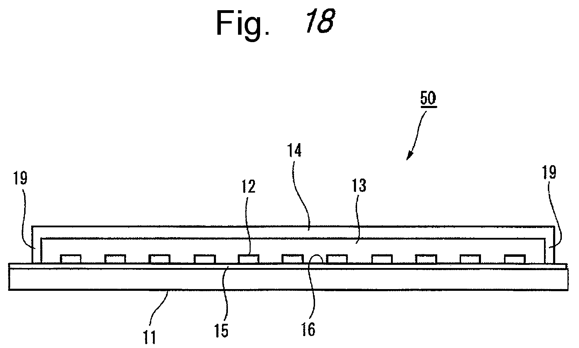

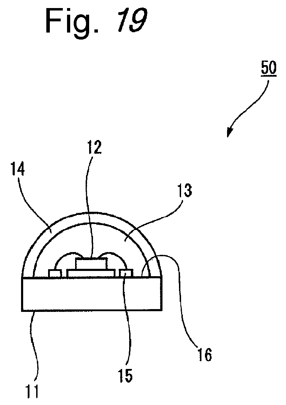

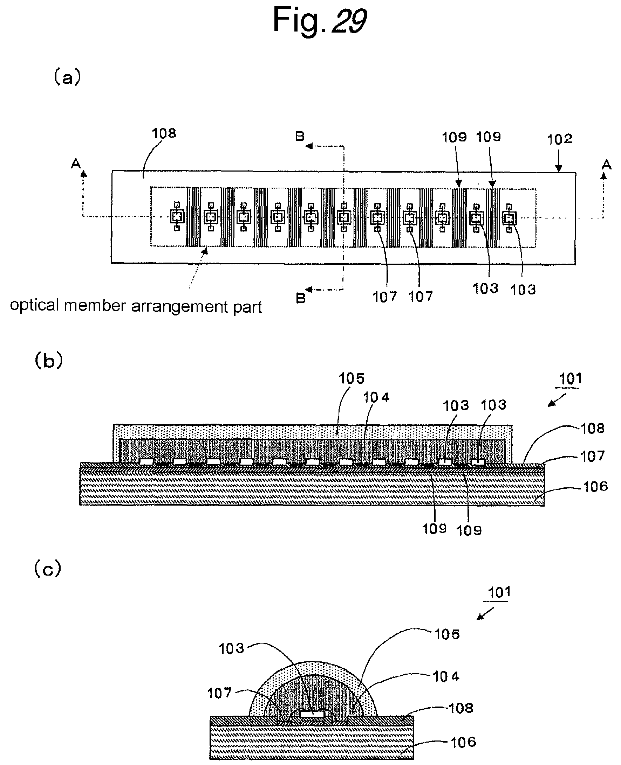

Next, a light emitting device of a fourth embodiment according to the present invention is described. As illustrated in Fig. 17, the light emitting device 50 of the fourth embodiment according to the present invention is configured such that end sides of a wiring board 11 and wavelength converting member 14 on a width direction side (shorter side) orthogonal to a length direction of the wiring board 11 and the wavelength converting member 14 coincide in position with each other. As illustrated in Figs. 18 and 19, the light emitting device 50 is configured such that the end sides of the wiring board 11 and the wavelength converting member 14 on the width direction side coincide in position with each other, and therefore by bringing a plurality of adjacent one sides on the width direction side close to each other, a uniform surface emitting light source can be easily formed.

According to the light emitting device 50 of the fourth embodiment according to the present invention, when multiple pieces are adjacently arranged, a size and a shape of a continuous emission surface can be easily changed.

### (Fifth embodiment)

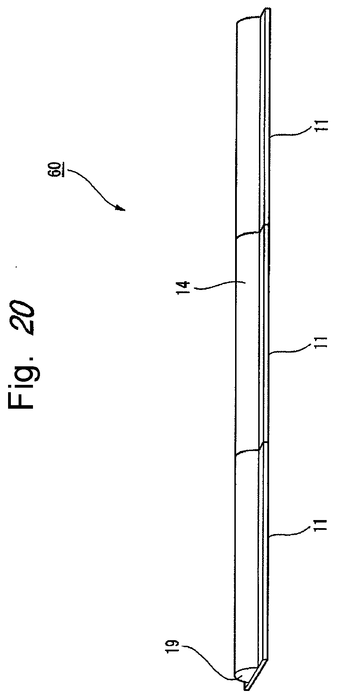

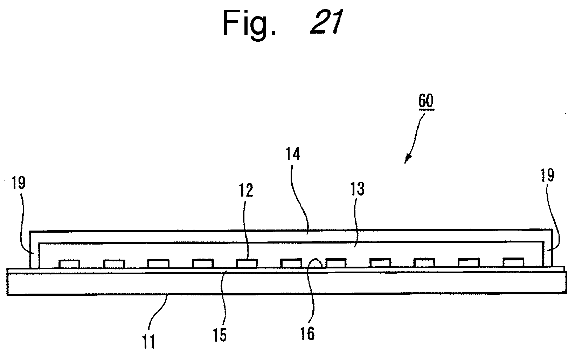

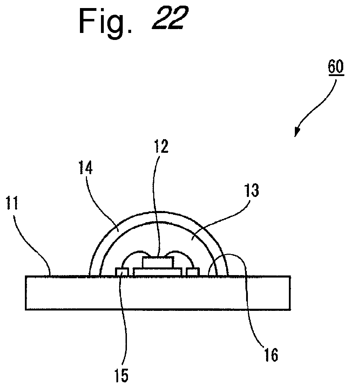

Next, a light emitting device of a fifth embodiment according to the present invention is described. As illustrated in Fig. 20, the light emitting device 60 of the fifth embodiment according to the present invention is configured such that end sides of the wiring board 11 and the wavelength converting member 14 on a length direction side (longer side) coincide in position with each other. As illustrated in Figs. 21 and 22, the light emitting device 60 is configured such that the end sides of the wiring board 11 and the wavelength converting member 14 on the length direction side coincide in position with each other, and therefore by bringing a plurality of adjacent one sides on the length direction side close to each other without any space, a uniform line emitting light source can be easily formed.

### (Sixth embodiment)

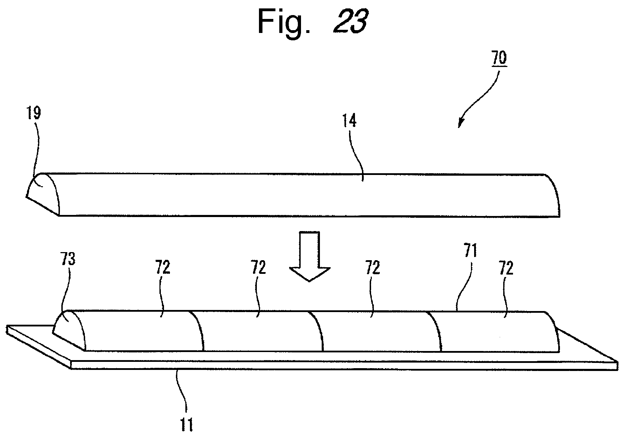

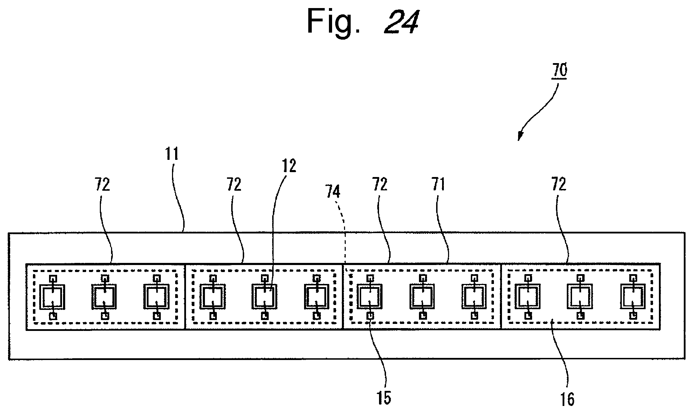

Next, a light emitting device of a sixth embodiment according to the present invention is described. As illustrated in Figs. 23 and 24, the light emitting device 70 of the sixth embodiment according to the present invention is provided with an optical member 71 including a plurality of short-sized divided optical member parts 72. At ends of each of the short-sized optical member parts 72, walls 73 having a thickness thinner than a mounting interval between solid-state light emitting elements 12 are formed. A size of each of the short-sized optical member parts 72 is adapted such that the wall 73 is positioned at the midpoint between specific adjacent solid-state light emitting elements 12.

Next, a procedure for forming the optical member 71 in the light emitting device 70 is described. When the optical member 71 is formed, concave portions 74 of the short-sized optical member parts 72 are filled with a transparent silicone resin material and mounted from an end of the solid-state light emitting elements 12. Then, adjacent short-sized optical member parts 72 are joined to each other through the transparent silicone resin material. At this time, the transparent silicone resin material to be filled, short-sized optical member parts 72, and transparent silicone resin material are made of the same material, and thereby after curing, an integrated structure without any interface can be formed.

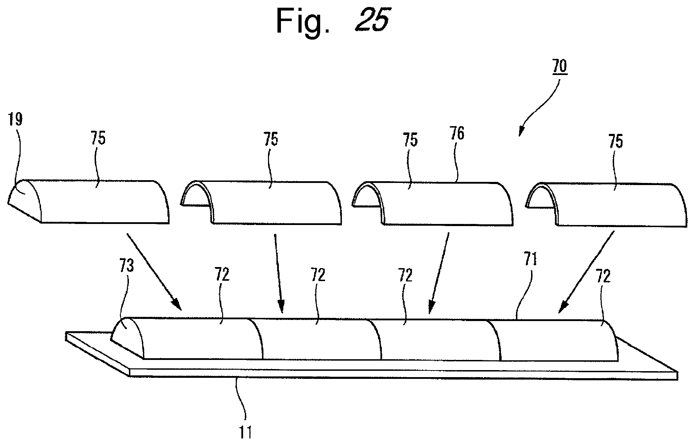

As illustrated in Fig. 25, a variation of the light emitting device 70 is provided with a wavelength converting member 76 including a plurality of short-sized divided wavelength converting member parts 75. In this case, the short-sized wavelength converting member parts 75 are preferably joined to each other through a silicone resin material containing the same phosphors as those of the wavelength converting member 76.

According to the light emitting device 70 of the sixth embodiment according to the present invention, by dividing the flexible optical member 71 or the wavelength converting member 76, molding is facilitated. Also, a void is unlikely to occur, so that yield is improved, and mounting is facilitated. This enables manufacturing cost to be reduced.

### (Seventh embodiment)

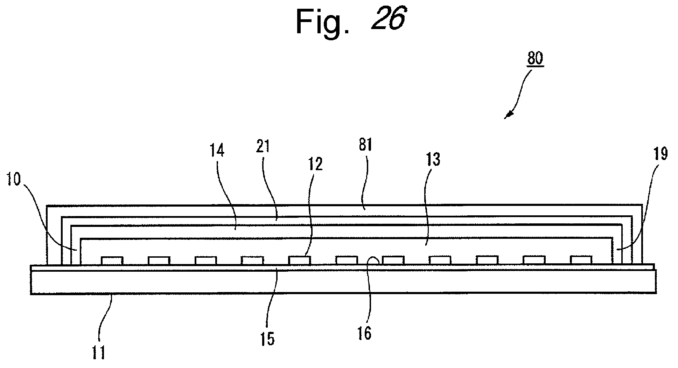

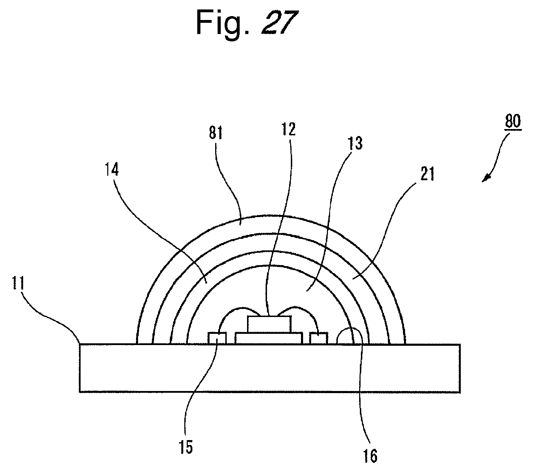

Next, a light emitting device of a seventh embodiment according to the present invention is described. As illustrated in Figs. 26 and 27, the light emitting device 80 of the seventh embodiment according to the present invention is provided with a translucent acrylic cover 81, which has a shape similar to that of a wavelength converting member 14, through the air layer 21 so as to cover the wavelength converting member 14. As a material for the cover 81, transparent resin such as polycarbonate or glass is selected.

Note that, if the cover 81 is in close contact with the wavelength converting member 14, due to thermal expansion/shrinkage between the members, peeling at an interface occurs, or due to fixation, a static load is easily placed on the wavelength converting member 14 and the optical member 13 to reduce reliability. However, the cover 81 is provided separately from the wavelength converting member 14, and therefore neither the peeling at the interface nor the reduction in reliability occurs.

According to the light emitting device 80 of the seventh embodiment according to the present invention, the cover 81 covers a light emitting part, and thereby any damage (e.g., wire disconnection, peeling, or scratch) due to an external load can be prevented. According to the light emitting device 80 of the seventh embodiment according to the present invention, this enables solid-state light emitting elements 12 to be protected from outside.

Note that the light emitting device of the present invention is not limited to that in any of the above-described embodiments, but appropriate modification, improvement, or the like can be made. In any of the above-described embodiments, the case where the number of the solid-state light emitting elements is 10 is described; however, without limitation to this, the number of the solid-state light emitting elements may be plural such as not more than 10 or not less than 10.

As illustrated in Figs, 1 and 2, a light emitting device 101 of the present embodiment is provided with: a long-sized wiring board 102; a plurality of solid-state light emitting elements 103 (hereinafter referred to as light emitting elements) mounted on the wiring board 102; an optical member 104 (first translucent resin layer) that covers the plurality of light emitting elements 103; and a wavelength converting member 105 (light conversion part) that covers the optical member 104. The wiring board 102 includes: a wiring board base material 106; a wiring pattern 107 formed on the wiring board base material 106; and a white resist 106 formed on the wiring pattern 107.

The plurality of light emitting elements 103 are mounted on the wiring board 102 in line along a length direction of the wiring board 102 at regular intervals. As such light emitting elements 103, for example, blue LEDs or the like made with use of nitride semiconductor or the like are used.

The optical member 104 is made of a resin material having translucency, such as transparent silicone resin; is gutter-shaped in the length direction; and has a semicircular cross-sectional shape that is orthogonal to the length direction. Inside the optical member 104 including the center of a cross section of the optical member 104, a concave portion is formed so as to contain the plurality of light emitting elements 103 inside. At both ends of the optical member 104, lid parts not having a concave portion are formed. An outside diameter of the cross section of the optical member 104 is equal to or more than a number obtained by multiplying a diameter of a circumscribed circle of the plurality of solid-state light emitting elements 103 by a refractive index (in the case of the silicone resin, 1.41 time) of the optical member 104. In the concave portion formed in the optical member 104, resin having the same refractive index as that of the optical member 104 is filled, and thereby the optical member 104 seals the light emitting elements 103. After the filled resin has cured, it forms a structure integral with the optical member 104 to prevent an interface to be formed. An outer surface that is a circumferential curved surface of the optical member 104 serves as a light lead-out surface that leads out blue light emitted from the light emitting elements 103 outside the optical member 104.

The wavelength converting member 105 contains phosphors (yellow phosphors) that convert the blue light emitted from the plurality of light emitting elements 103 to yellow light. The wavelength converting member 105 is formed in a sheet-like shape so as to cover the light lead-out surface of the optical member 104. Also, between the light lead-out surface and the wavelength converting member 105, a layer made of a resin material (second translucent resin layer) or air layer may intervene.

A diffusion part 109 that diffuses the light emitted from the plurality of light emitting elements 103 is formed between adjacent light emitting elements 103. Note that a site between adjacent light emitting elements 103 includes, in a width direction orthogonal to an array direction of the light emitting elements, a region where the optical member 104 is arranged (optical member arrangement part), and in a vertical direction, a region from a bottom surface of the wiring board 102 to an upper surface of the wavelength converting member 105. The diffusion part 109 is configured to have, for example, a concave-convex shape formed in the white resist 108 between light emitting elements 103. The light diffused by the diffusion part 109 is emitted above the diffusion part 109. As the diffusion part 109, in addition to forming the concave-convex shape, for example, diffusing particles may be arranged.

The wiring board base material 106 is formed with use of, for example, metal such as aluminum as a base material. The wiring pattern 107 has conductive property, and is formed in a predetermined pattern so as to be able to supply electricity to the plurality of light emitting elements 103. The white resist 108 has a high reflectance.

An emission peak wavelength of the blue light emitted from the plurality of light emitting elements 103 is, for example, 460 nm, and a size of each of the light emitting elements 103 is, for example, 0.3 mm. A mounting method for the plurality of light emitting elements 103 employs a combination of die bonding and wire bonding. As the mounting method, in addition to the above, flip-chip bonding may be used, and the type and size of the light emitting element are not limited to the above-described ones. The plurality of light emitting elements 103 may be arranged in a plurality of lines.

Also, as a material for the optical member 104, in addition to the transparent silicone resin, epoxy resin, or an inorganic material such as glass may be used. An outer shape of the optical member 104 may be a semielliptical shape.

Further, as a material for the wavelength converting member 105, transparent heat-resistant resin having a refractive index of 1.2 to 1.7 such as silicone resin is preferably used. A thickness of the wavelength converting member 105 is preferably set to 0.5 to 1.0 mm. As the phosphors contained in the wavelength converting member 105, for example, red phosphors and green phosphors may be mixed. This enables white light having high color rendering properties to be obtained. The wavelength converting member 105 may be formed by being coated on a surface of the optical member 104.

Still further, a size of the wiring board 102 is a length dimension of 200 mm × a width dimension of 20 mm. As a material for the wiring board base material 102, for example, glass epoxy or ceramic may be used. Note that, in Fig. 2(a), the optical member 104 and the wavelength converting member 105 are not illustrated.

Next, a light emitting method of the above light emitting device 101 is described. As illustrated in Figs. 3 and 4, part of the blue light emitted from the plurality of light emitting elements 103 passes through the optical member 104 and is irradiated on the wavelength converting member 105. Part of the blue light irradiated on the wavelength converting member 105 is irradiated on the phosphors contained in the wavelength converting member 105. The blue light irradiated on the phosphors is converted to the yellow light by the phosphors, and the yellow light is emitted from the phosphors. As a result, blue light not irradiated on the phosphors and the yellow light are combined and emitted as white light from the surface of the wavelength converting member 105.

The blue light emitted from the light emitting elements 103 includes blue light that is totally reflected by the light lead-out surface. Part of the totally reflected blue light is irradiated on the diffusion parts 109. The blue light irradiated on the diffusion parts 109 passes through the optical member 104; is irradiated on the wavelength converting member 105 positioned above the diffusion parts 109; and is emitted from the surface of the wavelength converting member 105. In this case, not only from the light emitting elements 103 but also from the sites between adjacent light emitting elements 103, the light is irradiated on the wavelength converting member 105, and therefore a ratio of light irradiated on the phosphors can be easily made substantially the same between the wavelength converting member 105 positioned above the light emitting elements 103 and the wavelength converting member 105 positioned above the diffusion parts 109. Note that, when the blue light is led to the wavelength converting member 105, in the same manner as above, the blue light and the yellow light are combined and emitted as white light from the surface of the wavelength converting member 105. Arrows illustrated in Fig. 3 indicate paths of light emitted from one of the light emitting elements 103.

The wavelength converting member 105 is formed in a semicircular cross-sectional shape around an array of the light emitting elements 103. Also, an outer surface that is a circumferential curved surface of the wavelength converting member 105 is sufficiently large in size with respect to an emission surface of each of the light emitting elements 103. Note that, in Fig. 4, the light emitting element 103 is illustrated larger than the other members. For this reason, incident angle regions toward incident points A, B, and C where the blue light is incident on the wavelength converting member 105 are decreased, and made equal to one another. As a result, reflection on the surface of the wavelength converting member 105 is reduced, and therefore light can be efficiently extracted. Also, light path lengths in the wavelength converting member 105 are uniformized, and therefore a ratio of the blue light that is converted to the yellow light by the phosphors in the wavelength converting member 105 can be easily made substantially uniform. As a result, luminance unevenness and color unevenness on the surface of the wavelength converting member 105 can be reduced.

As described, according to the light emitting device 101 of the present embodiment, the light emitted from the plurality of light emitting elements 103 is diffused by the diffusion parts 109 formed between adjacent light emitting elements 103, and irradiated on the wavelength converting member 105 containing the phosphors through the optical member 104. In this manner, not only from the light emitting elements 103, but also from the sites between adjacent light emitting elements 103, the light is irradiated on the wavelength converting member 105, and therefore a ratio in light irradiated on the phosphors can be made substantially the same between the wavelength converting member 105 positioned above the light emitting elements 103 and the wavelength converting member 105 positioned above the diffusion parts 109. As a result, the light can be easily made to substantially equally pass through a whole of the wavelength converting member 105, and therefore the luminance unevenness and the color unevenness on the surface of the wavelength converting member 105 can be reduced.

### (Eighth embodiment)

Next, a light emitting device 101 according to a first variation is described referring to Fig. 5. In this variation, diffusion parts 109 are configured such that, for example, a diffusing material is arranged in an optical member 104 between adjacent light emitting elements 103. Also, the optical member 104 is covered by a wavelength converting member 105 through an air layer 110. Even in this variation, the same effect as that in any of the above-described embodiments can be obtained, and total reflection of blue light on a light lead-out surface of the optical member 104 is increased to increase blue light led in a length direction in the optical member 104, so that blue light diffused by each of the diffusion parts 109 is increased. Based on this, the blue light can be easily made to be equally led to a whole of the wavelength converting member 105. As a result, luminance unevenness and color unevenness on a surface of the wavelength converting member 105 are further reduced.

### (Ninth embodiment)

Next, a light emitting device 101 according to a second variation is described referring to Fig. 6. In this variation, diffusion parts 109 are configured such that a light lead-out surface of an optical member 104 positioned above sites between adjacent light emitting elements 103 is formed in a concave-convex shape. Also, the optical member 104 is covered by a wavelength converting member 105 through an air layer 110. Even in this variation, the same effect as above can be obtained.

### (Tenth embodiment)

Next, a light emitting device 101 according to a third variation is described referring to Fig. 7. In this variation, diffusion parts 109 are configured such that, for example, diffusing particles are arranged in an air layer 110 that is positioned on a light lead-out surface and above sites between adjacent light emitting elements 103. Even in this variation, an amount of light vertically led from the air layer 110 to a wavelength converting member 105 can be increased, and therefore the same effect as above can be obtained.

### (Eleventh embodiment)

Next, a light emitting device 101 according to a fourth variation is described referring to Fig. 8. In this variation, diffusion parts 109 are configured such that, for example, diffusing particles are formed in a wavelength converting member 105 that is positioned above sites between adjacent light emitting elements 103. In this variation, a vertical component of light led to the wavelength converting member 105 can be increased, and therefore the same effect as above can be obtained.

### (Twelfth embodiment)

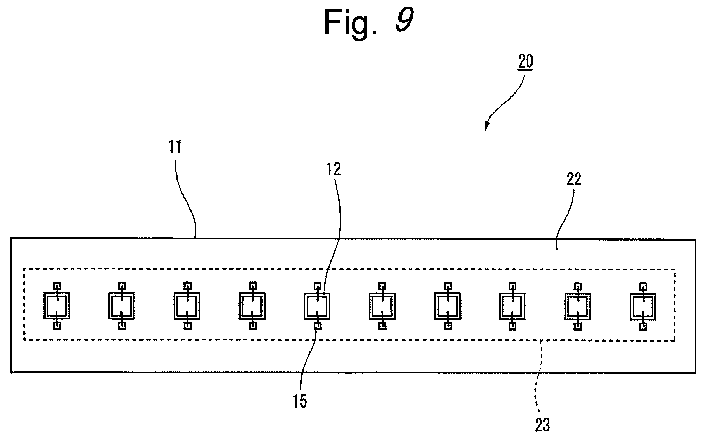

Next, a light emitting device 101 according to a fifth variation is described referring to Fig. 9. In this variation, diffusion parts 109 are configured such that, for example, a white resist 108 between adjacent light emitting elements 103 is formed in a concave-convex shape. A diffusion degree of each of the diffusion parts 109 is increased toward an intermediate position between adjacent light emitting elements 103, and decreased toward a light emitting element 103. In general, weakest blue light in blue light passing through an optical member 104 is obliquely irradiated on the intermediate position between adjacent light emitting elements 103. In this variation, light irradiated on each of the diffusion parts 109 is diffused so as to be more intensely irradiated vertically on a wavelength converting member 105 as the light comes close to the intermediate position, and therefore the same effect as above can be obtained. Note that the diffusion parts 109 may be configured such that the optical member 104 between adjacent light emitting elements 103 is formed in a concave-convex shape.

### (Thirteenth embodiment)

Next, a light emitting device 101 according to a sixth variation is described referring to Fig. 10. In this variation, diffusion parts 109 are configured such that, for example, a plurality of convex portions made of white resist 108 are continuously formed between adjacent light emitting elements 103 on a wiring board 102. A vertically cross-sectional shape of each of the plurality of convex portions is a triangle, and a shape of the triangle is different depending on a position where each of the concave portions is formed. An inclination angle of a triangle on a side close to a light emitting element 103 is small, whereas it on a side distant from the light emitting element 103 is large. Figs. 11 (a) to (c) illustrate a first convex portion formed adjacent to a light emitting element 103, a second convex portion formed in the center between adjacent light emitting elements 103, and a third convex portion formed between the first and second convex portions.

As illustrated in Fig. 11 (a), it is assumed that an angle of one of inclined surfaces of the first convex portion is denoted by θ1a, and an angle of the other inclined surface by θ1b. As illustrated in Fig. 11 (b), it is assumed that an angle of one of inclined surfaces of the second convex portion is denoted by θ2a, and an angle of the other inclined surface by θ2b. As illustrated in Fig. 11 (3), it is assumed that an angle of one of inclined surfaces of the first convex portion is denoted by θ3a, and an angle of the other inclined surface by θ3b. The diffusion part 109 is formed such that a relationship among the respective inclined surface angles meets θ1a < θ3a < θ2a = θ2b < θ3b < θ1b. In this variation, an amount of light irradiated on a light lead-out surface in substantially the center between adjacent light emitting elements 103 can be increased, and therefore the same effect as above can be obtained.

### (Fourteenth embodiment)

Next, a light emitting device 101 according to a seventh variation is described referring to Figs. 12 (a) to (c). As illustrated in Figs. 12 (a) and (b), in this variation, a plurality of (nine in this variation) light emitting elements 103 are arranged in a planar shape (3 rows × 3 columns) on a rectangular wiring board 102. Also, diffusion parts 109 are, as in the above fifth variation, configured such that white resists 108 between adjacent light emitting elements 103 are formed in a concave-convex shape. In addition, as illustrated in Fig. 12 (c), the diffusion parts 109 may be, as in the above sixth variation, configured such that a plurality of convex portions made of white resist 108 are continuously formed between adjacent light emitting elements 103 on the wiring board 102. The plurality of light emitting elements 103 may be arranged in, in addition to the planar shape, a linear shape or a stereoscopic surface shape on a surface of a straight pipe, or the like. Even in this variation, the same effect as above can be obtained. Note that, instead of forming the white resist 108 in the concave-convex shape, the optical member 104 or the wavelength converting member 105 may be formed in the concave-convex shape.

The present invention is not limited to the configuration of any of the above-described embodiments, but can be variously modified without departing from the scope of the present invention. For example, in the above, as the light emitting element 103, a light emitting diode (LED) is used; however, without limitation to this, an organic electroluminescent element (organic EL element) or the like can be used. Also, the diffusion part 109 is not limited to forming a base material such as the white resist 108 in the concave-convex shape as described above if it can diffuse light, but may be configured by coating a light diffusing film on the wiring board 102. Also, in the above, the configuration in which the white resist 108 is formed on the wiring pattern 107 is described; however, without limitation to this, various types of resist that can reflect light can be used.

### [Description of Reference Numerals]

10, 20, 30, 50, 60, 70, 80: Light emitting device
11: Wiring board
12: Solid-state light emitting element
13, 31, 71: Optical member
14, 76: Wavelength converting member (light emitting part)
21: Air layer
32: Concave portion
72: Short-sized optical member part (optical part)
75: Short-sized wavelength converting member part (wavelength converting part)
101: Light emitting device
103: Solid-state light emitting element
104: Optical member (first translucent resin layer)
105: Wavelength converting member (light converting part)
109: Diffusion part
101: Air layer

## Claims

1. A light emitting device comprising:
a plurality of solid-state light emitting elements (12) that are mounted on a long-sized wiring board (11):
an optical member (13) mounted on the wiring board (11) that is provided in common covering the plurality of solid-state light emitting elements (12) thereby seal, mount, and fix said elements, the optical member (13) has a semicircular or semielliptical cross-sectional shape, and is gutter-shaped in a longer direction; the concave portion (17) inside the optical member (13) is filled with silicone resin having the same refractive index as the optical member (13); and
a wavelength converting member (14) that covers a light lead-out surface of the optical member (13), is excited by light led out of the solid-state light emitting elements (12), and emits wavelength-converted light.

2. The light emitting element according to claim 1, wherein
a region of a surface of the wiring board (11) has a high reflectance, the region including at least a lower surface of the optical member (12).

3. The light emitting device according to claim 1 or 2, wherein
between the optical member (12) and the wavelength converting member (14), an air layer (21) is present.

4. The light emitting device according to claim 1 or 2, further comprising,
between the optical member (31) and the wiring board (11) mounted with the plurality of solid-state light emitting elements (12), a frame body (33) that has a concave portion (32) that contains the plurality of solid-state light emitting elements (12), wherein in a state where the concave portion (32) contains the plurality of solid-state light emitting elements (12), a part of the optical member (31) is embedded in the concave portion (32).

5. The light emitting device according to claim 1 or 2, wherein
at least ones of end sides of the wiring board (11) and the wavelength converting member (14) substantially coincide in position with each other, the ones being on a same side.

6. The light emitting device according to claim 1 or 2, wherein
the optical member (71) includes a plurality of optical parts (72), and is integrally formed in a substantially long-sized shape.

7. The light emitting device according to claim 1 or 2, wherein
the wavelength converting member (76) includes a plurality of wavelength converting parts (75), and is integrally formed in a substantially long-sized shape.

8. A light emitting device (101) according to claim 1
comprising:
a plurality of solid-state light emitting elements (103);
a first translucent resin layer (104) that covers the plurality of solid-state light emitting elements (103);
a light converting part (105) that covers a light lead-out surface of the first translucent resin layer (104) directly or through a second translucent resin layer or an air layer, and contains a phosphor that converts a wavelength of emission light of the plurality of solid-state light emitting elements (103); and
a diffusion part (109) that is formed between the plurality of solid-state light emitting elements (103) and diffuses the light emitted from the plurality of solid-state light emitting elements (103).

9. The light emitting device according to claim 8, wherein
the diffusion part (109) is formed in the first translucent resin layer (104).

10. The light emitting device according to claim 8, wherein
the diffusion part (109) is formed on the light lead-out surface of the first translucent resin layer (104).

11. The light emitting device according to claim 8, wherein
the diffusion part (109) is formed between the first translucent resin layer (104) and the light converting part (105).

12. The light emitting device according to claim 8, wherein
the diffusion part (109) is formed in the light converting part (105).

13. The light emitting device according to claim 8, wherein
the diffusion part (109) has a diffusion degree that is increased toward an intermediate position between mutually adjacent solid-state light emitting elements (103), and is decreased toward any of the solid-state light emitting elements (103).

14. The light emitting device according to claim 8, wherein:
the diffusion part (109) is formed on a board mounted with the plurality of solid-state light emitting elements (103); a vertically cross-sectional shape of the diffusion part (109) along one side of the board is a triangle; an inclination angle of the triangle on a side close to a solid-state light emitting element (103) is small; and an inclination angle of the triangle on a side distant from the solid-state light emitting element (103) is large.

15. The light emitting device according to any of claims 8 to 12, wherein
the plurality of solid-state light emitting elements (103) are arranged in a linear shape, a planar shape, or a stereoscopic surface shape.

## Patentansprüche

1. Lichtabstrahlvorrichtung aufweisend:
eine Mehrzahl von Festkörperlichtabstrahlelementen (12), die auf einer länglichen Leiterplatte (11) angebracht sind;
ein optisches Element (13), das auf der Leiterplatte (11) angebracht und das dazu vorgesehen ist, die Mehrzahl von Festkörperlichtabstrahlelementen (12) gemeinsam abzudecken und dabei diese Elemente abzudichten, anzubringen und zu befestigen, wobei das optische Element (13) eine halbkreisförmige oder halbelliptische Querschnittskontur aufweist und in einer längeren Richtung rinnenförmig ist; wobei der konkave Abschnitt (17) im Inneren des optischen Elements (13) mit einem Silikonharz gefüllt ist, das denselben Brechungsindex wie das optische Element (13) aufweist; und
ein Wellenlängenänderungselement (14), das eine Lichtabstrahlfläche des optischen Elements (13) abdeckt, wird durch das von den Festkörperlichtabstrahlelementen (12) abgegebene Licht angeregt und strahlt Licht mit geänderter Wellenlänge ab.

2. Lichtabstrahlvorrichtung nach Anspruch 1, wobei ein Bereich einer Oberfläche der Leiterplatte (11) eine hohe Reflektanz aufweist, wobei der Bereich zumindest eine untere Fläche des optischen Elements (12) enthält.

3. Lichtabstrahlvorrichtung nach Anspruch 1 oder 2, wobei zwischen dem optischen Element (12) und dem Wellenlängenänderungselement (14) eine Luftschicht (21) vorhanden ist.

4. Lichtabstrahlvorrichtung nach Anspruch 1 oder 2, außerdem aufweisend,
einen Rahmenkörper (33), der zwischen dem optischen Element (31) und der Leiterplatte (11) mit der Mehrzahl von Festkörperlichtabstrahlelementen (12) angebracht ist, der einen konkaven Abschnitt (32) aufweist, der die Mehrzahl von Festkörperlichtabstrahlelementen (12) enthält, wobei ein Teil des optischen Elements (31) in dem konkaven Bereich (32) aufgenommen ist, wenn der konkave Bereich (32) die Mehrzahl von Festkörperlichtabstrahlelementen (12) enthält.

5. Lichtabstrahlvorrichtung nach Anspruch 1 oder 2, wobei zumindest die einen der Endseiten der Leiterplatte (11) und des Wellenlängenänderungselements (14) in ihren Positionen im Wesentlichen miteinander übereinstimmen, wobei diese Einen auf derselben Seite angeordnet sind.

6. Lichtabstrahlvorrichtung nach Anspruch 1 oder 2, wobei das optische Element (71) eine Mehrzahl von optischen Teilen (72) aufweist und integral in einer im Wesentlichen länglichen Gestalt ausgeführt ist.

7. Lichtabstrahlvorrichtung nach Anspruch 1 oder 2, wobei das Wellenlängenänderungselement (76) eine Mehrzahl von Wellenlängenwandlungsteilen (75) aufweist und integral in einer im Wesentlichen länglichen Gestalt ausgeführt ist.

8. Lichtabstrahlvorrichtung (101) nach Anspruch 1, aufweisend:
eine Mehrzahl von Festkörperlichtabstrahlelementen (103);
eine erste lichtdurchlässige Harzschicht (104), die die Mehrzahl von Festkörperlichtabstrahlelementen (103) abdeckt;
einen Lichtänderungsteil (105), der eine Lichtaustrittsfläche der ersten lichtdurchlässigen Harzschicht (104) unmittelbar oder über eine zweite lichtdurchlässige Harzschicht oder eine Luftschicht abdeckt und einen Phosphor enthält, der eine Wellenlänge des abgestrahlten Lichts der Mehrzahl von Festkörperlichtabstrahlelementen (103) ändert; und
einen Diffusionsteil (109), der zwischen der Mehrzahl von Festkörperlichtabstrahlelementen (103) ausgebildet ist und das von der Mehrzahl von Festkörperlichtabstrahlelementen (103) abgestrahlte Licht streut.

9. Lichtabstrahlvorrichtung nach Anspruch 8, wobei der Diffusionsteil (109) in der ersten lichtdurchlässigen Harzschicht (104) ausgebildet ist.

10. Lichtabstrahlvorrichtung nach Anspruch 8, wobei der Diffusionsteil (109) auf der Lichtaustrittsfläche der ersten lichtdurchlässigen Harzschicht (104) ausgebildet ist.

11. Lichtabstrahlvorrichtung nach Anspruch 8, wobei der Diffusionsteil (109) zwischen der ersten lichtdurchlässigen Harzschicht (104) und dem Lichtänderungsteil (105) ausgebildet ist.

12. Lichtabstrahlvorrichtung nach Anspruch 8, wobei der Diffusionsteil (109) in dem Lichtänderungsteil (105) ausgebildet ist.

13. Lichtabstrahlvorrichtung nach Anspruch 8, wobei der Diffusionsteil (109) einen Diffusionsgrad aufweist, der zu einer Zwischenposition zwischen zueinander benachbarten Festkörperlichtabstrahlelementen (103) hin zunimmt und in Richtung zu irgendeinem der Festkörperlichtabstrahlelemente (103) abnimmt.

14. Lichtabstrahlvorrichtung nach Anspruch 8, wobei:
der Diffusionsteil (109) auf einen Träger mit der Mehrzahl von Festkörperlichtabstrahlelementen (103) ausgebildet ist;
eine vertikale Querschnittsgestalt des Diffusionsteils (109) entlang einer Seite des Trägers ein Dreieck ist;
ein Neigungswinkel des Dreiecks auf einer Seite nahe bei einem Festkörperlichtabstrahlelement (103) klein ist; und ein Neigungswinkel des Dreiecks auf einer Seite entfernt von dem Lichtabstrahlelement (103) groß ist.

15. Lichtabstrahlvorrichtung nach einem der Ansprüche 8 bis 12, wobei die Mehrzahl von Festkörperlichtabstrahlelementen (103) in einer linearen Gestalt, einer ebenen Gestalt oder einer räumlichen Oberflächengestalt angeordnet ist.

## Revendications

1. Dispositif électroluminescent, comportant :
une pluralité d'éléments électroluminescents à semiconducteurs (12) montés sur une longue carte de câblage (11) ;
un composant optique (13) monté sur la carte de câblage (11), qui est disposé de manière à couvrir en commun la pluralité d'éléments électroluminescents à semiconducteurs (12) pour ainsi enfermer hermétiquement, supporter et immobiliser lesdits éléments, le composant optique (13) ayant une section transversale de forme semi-circulaire ou semi-elliptique et ayant une forme en gouttière dans la direction la plus grande ; la partie concave (17) à l'intérieur du composant optique (13) étant remplie de résine silicone ayant le même indice de réfraction que le composant optique (13) ; et
un composant de conversion de longueur d'onde (14) qui couvre une surface de sortie de lumière du composant optique (13) et qui est excité par la lumière issue des éléments électroluminescents à semiconducteurs (12) et émet de la lumière à longueur d'onde convertie.

2. Elément électroluminescent selon la revendication 1, dans lequel
une zone d'une surface de la carte de câblage (11) a une grande réflectance, la zone comprenant au moins une surface inférieure du composant optique (12).

3. Dispositif électroluminescent selon la revendication 1 ou 2, dans lequel
entre le composant optique (12) et le composant de conversion de longueur d'onde (14) est présente une couche d'air (21).

4. Dispositif électroluminescent selon la revendication 1 ou 2, comportant en outre
entre le composant optique (31) et la carte de câblage (11) sur laquelle est montée la pluralité d'éléments électroluminescents à semiconducteurs (12), un corps formant bâti (33) qui a une partie concave (32) contenant la pluralité d'éléments électroluminescents à semiconducteurs (12), une partie du composant optique (31), dans un état où la partie concave (32) contient la pluralité d'éléments électroluminescents à semiconducteurs (12), étant encastrée dans la partie concave (32).

5. Dispositif électroluminescent selon la revendication 1 ou 2, dans lequel
les positions d'au moins certaines des extrémités de la carte de câblage (11) et du composant de conversion de longueur d'onde (14) coïncident sensiblement les unes avec les autres, ces certaines extrémités se trouvant d'un même côté.

6. Dispositif électroluminescent selon la revendication 1 ou 2, dans lequel le composant optique (71) comprend une pluralité de parties optiques (72) et est formé d'un seul tenant sous une forme sensiblement longue.

7. Dispositif électroluminescent selon la revendication 1 ou 2, dans lequel le composant de conversion de longueur d'onde (76) comprend une pluralité de parties de conversion de longueur d'onde (75) et est formé d'un seul tenant sous une forme sensiblement longue.

8. Dispositif électroluminescent (101) selon la revendication 1, comportant :
une pluralité d'éléments électroluminescents à semiconducteurs (103) ;
une première couche de résine translucide (104) qui couvre la pluralité d'éléments électroluminescents à semiconducteurs (103) ;
un moyen de conversion de lumière (105) qui couvre une surface de sortie de lumière de la première couche de résine translucide (104) directement ou à travers une seconde couche de résine translucide ou une couche d'air, et contient un luminophore qui convertit une longueur d'onde de lumière d'émission de la pluralité d'éléments électroluminescents à semiconducteurs (103) ; et
un moyen de diffusion (109) qui est formé entre la pluralité d'éléments électroluminescents à semiconducteurs (103) et diffuse la lumière émise par la pluralité d'éléments électroluminescents à semiconducteurs (103).

9. Dispositif électroluminescent selon la revendication 8, dans lequel
le moyen de diffusion (109) est formé dans la première couche de résine translucide (104).

10. Dispositif électroluminescent selon la revendication 8, dans lequel
le moyen de diffusion (109) est formé sur la surface de sortie de lumière de la première couche de résine translucide (104).

11. Dispositif électroluminescent selon la revendication 8, dans lequel
le moyen de diffusion (109) est formé entre la première couche de résine translucide (104) et le moyen de conversion de lumière (105).

12. Dispositif électroluminescent selon la revendication 8, dans lequel
le moyen de diffusion (109) est formé dans le moyen de conversion de lumière (105).

13. Dispositif électroluminescent selon la revendication 8, dans lequel
le moyen de diffusion (109) a un degré de diffusion qui augmente vers une position intermédiaire entre des éléments électroluminescents à semiconducteurs mutuellement adjacents (103) et qui diminue vers l'un quelconque des éléments électroluminescents à semiconducteurs (103).

14. Dispositif électroluminescent selon la revendication 8, dans lequel :
le moyen de diffusion (109) est formé sur une carte sur laquelle est montée la pluralité d'éléments électroluminescents à semiconducteurs (103) ; une forme verticalement en coupe du moyen de diffusion (109) sur un côté de la carte est un triangle ; un angle d'inclinaison du triangle sur un côté proche d'un élément électroluminescent à semiconducteur (103) est petit ; et un angle d'inclinaison du triangle sur un côté distant de l'élément électroluminescent à semiconducteur (103) est grand.

15. Dispositif électroluminescent selon l'une quelconque des revendications 8 à 12, dans lequel
la pluralité d'éléments électroluminescents à semiconducteurs (103) sont disposés sous une forme linéaire, une forme plane ou une forme de surface stéréoscopique.
